# EUROPÄISCHE PATENTSCHRIFT

(11) **EP 0 600 118 B1**
(45) Veröffentlichungstag und Bekanntmachung des Hinweises auf die Patenterteilung: **27.05.1998**
(21) Anmeldenummer: 92120501.9
(22) Anmeldetag: 01.12.1992
(51) Int. Cl.: H03B 5/18

(54) **Spannungsgesteuerter Mikrowellen-Oszillator**
Voltage-controlled microwave oscillator
Oscillateur à micro-ondes commandé en tension

(43) Veröffentlichungstag der Anmeldung: 08.06.1994
(73) Patentinhaber: SIEMENS AKTIENGESELLSCHAFT, 80333 München (DE)
(72) Erfinder: Lohninger, Gerhard, Dipl.-Ing., W-8000 München 90 (DE)

(56) Entgegenhaltungen:
- EP-A- 61 952
- EP-A- 203 663
- EP-A- 221 608
- US-A- 4 463 322
- US-A- 4 775 845

## Beschreibung

Die Erfindung betrifft einen spannungsgesteuerten Mikrowellen- Oszillator mit einem Feldeffekttransistor als Verstärker und einer Varaktordiode als frequenzbestimmendes Element.

Spannungsgesteuerte Mikrowellen-Oszillatoren sind bekannt. Bei einem solchen VCO (Voltage-controlled oscillator) wird ein durch eine Spannung veränderbarer Blindwiderstand, z.B. eine Kapazitätsdiode, in das frequenzbestimmende Glied des Oszillators geschaltet. Um nämlich beispielsweise die Frequenz eines Oszillators mit der Frequenz einer anderen Schwingung zu synchronisieren, muß die Oszillatorfrequenz durch eine Gleichspannung verändert werden können.

Bekannte spannungsgesteuerte Mikrowellen-Oszillatoren enthalten als aktives Bauelement (negativen Widerstand) neben Gunn-Dioden oder Impatt-Dioden auch Silizium-Bipolartransistoren oder Feldeffekttransistoren (FET). Weil relativ wenige bipolare Transistoren bei Frequenzen oberhalb von 12GHz effektiv arbeiten, werden für den Einsatz für Frequenzen in einem Bereicn von ca. 8GHz bis 12GHz (sogenanntes X-Band) GaAs-Feldeffekttransistoren verwendet. Bei solcnen FET-Oszillatoren ist beispielsweise zwischen eine (kapazitätsvariable) Varaktordiode und die Gate-Elektrode des FET's eine Induktivität in Serie geschaltet, um ein schwingungsfähiges Gebilde zu erhalten. Derartige Oszillatoren sind allerdings relativ lastempfindlich.

Der Erfindung liegt die Aufgabe zugrunde, einen spannungsgesteuerten Oszillator mit hoher Ausgangsleistung und ausreichend großem Frequenznub im Mikrowellen-Frequenzbereich, insbesondere für Frequenzen von ca. 8GHz bis 12GHz, zu schaffen und so auszubilden, daß S-Parameterstreuungen der aktiven Bauelemente (Feldeffekttransitor, Varaktor-Diode) möglichst geringen Einfluß auf die Kenndaten des Oszillators haben.

Diese Aufgabe wird bei einem spannungsgesteuerten Mikrowellen-Oszillator der eingangs genannten Art erfindungsgemäß dadurch gelöst, daß der Varaktordiode ein abstimmbares Mikro-Streifenleitungsfilter vorgeschaltet ist, und daß zum Bilden einer parallelen Rückkopplung mit dem Mikro-Streifenleitungsfilter die Source-Elektrode des Feldeffekttransistors direkt mit Masse verbunden ist.

Dabei werden als Feldeffekttransistor und als Varaktordiode vorzugsweise Bauelemente auf Galliumarsenidbasis als Verbindungshalbleitermaterial verwendet. Das Mikro-Streifenleitungsfilter ist vorteilhaft ein Drei-Streifen-Filter.

Beim parallelrückgekoppelten Oszillatorprinzip entsteht nur dann eine HF-Schwingung, wenn die Phasen- und Amplitudenbedingung im Rückkoppelzweig erfüllt ist. Bei Anlegen der Betriebsspannung an den Feldeffekttransistor (FET) ist die Scnleifenverstärkung größer 1 und die Signalphase ein Vielfaches von 2 π. Sind diese Eigenschaften nicht erfüllt, kann sich keine Schwingung ausbilden. Für die Ausgangsleistung eines Oszillators ist die Lastimpedanz und die Generatorimpedanz von entscheidender Bedeutung. Die Generatorimpedanz sowie die Pnasen- und Amplitudenbedingung werden von den S-Parametern des FET's bestimmt. Die Auswirkung von S-Parameter-Streuungen auf das Vernalten des Oszillators wird vorteilhaft durch die feste Masse- bzw. GND-(Ground-)Anbindung (möglichst geringe Induktivität) der Source-Elektrode des FET's reduziert, und zwar in Verbindung mit der parallelen Rückkopplung der Anordnung.

Von weiterem Vorteil ist die mit der Parallelrückkopplung erzielbare hohe Ausgangsleistung des Oszillators, wodurch das Streuproblem bei der Serienfertigung vereinfacht wird.

Die Frequenzänderung des Oszillators wird durch die Varaktor-Diode ermöglicht, die vorteilhaft so mit einer Filterstruktur verbunden ist, daß die Resonanzfrequenz und der Pnasengang des Filters entsprechend der am Varaktor angelegten Spannung variiert werden kann. Die Übertragungsverluste des Filters bleiben im Frequenzband nahezu konstant. Der Realteil der Eingangsimpedanz der Varaktor-Diode bestimmt dabei die Übertragungsverluste des Filters und sollte daher zweckmäßig möglichst klein gewählt werden.

Die mit der Erfindung erzielten Vorteile bestehen insbesondere darin, daß aufgrund des Parallelrückkopplungskonzeptes des Oszillators mit einem Mikro-Steifenleitungsfilter und einer mit einer Varaktor-Diode abgeschlossenen Mikrostreifenleitung, die die elektrischen Eigenscnaften des Filters beeinflußt, ein ausreichend großer Frequenznub von ca. ± 400 MHz erreicht wird, wobei die S-Parameterstreuungen von FET und Varaktordiode einem sehr geringen Einfluß auf die Kenndaten des Oszillators haben und die Ausgangsleistung hoch ist.

Anhand eines in den Figuren der Zeichnung dargestellten Ausfünrungsbeispiels wird die Erfindung im folgenden weiter erläutert. Es zeigen
- FIG 1: eine Prinzipschaltung des Mikrowellen-Oszillators und
- FIG 2: eine Ausführung des Mikro-Streifenleitungsfilters des Mikrowellenoszillators.

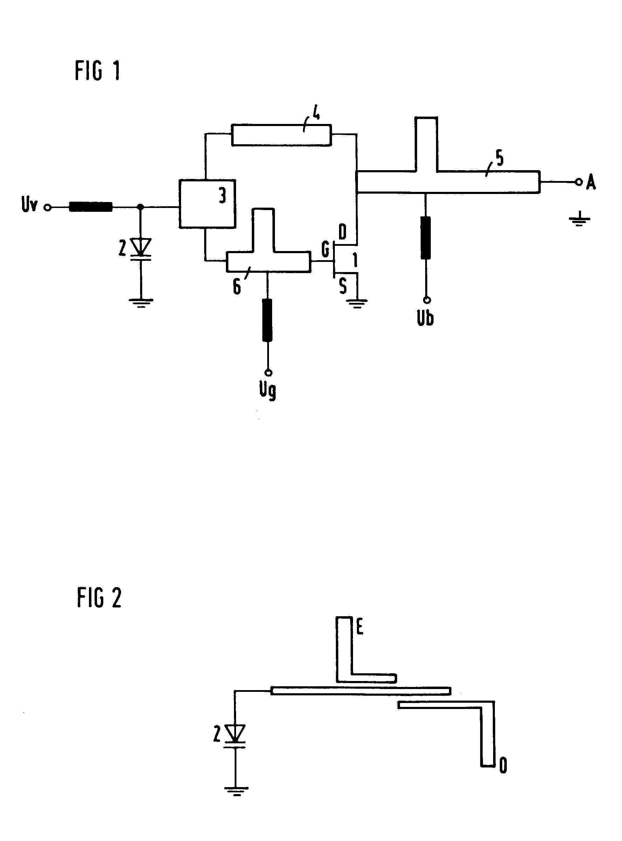

Der in FIG 1 dargestellte Mikrowellen-Oszillator weist als Verstärker einen GaAs-Feldeffekttransistor 1 mit einer Source-Elektrode S, einer Drain-Elektrode D und einer Gate-Elektrode G auf. Als frequenzbestimmendes Element ist eine GaAs-Varaktor-Diode 2 vorgesehen, an der eine Varaktor-Diodenspannung Uv von beispielsweise -1V bis -12V liegt. Der Varaktor-Diode 2 ist ein abstimmbares Mikro-Streifenleitungsfilter 3 vorgeschaltet. Zum Bilden einer parallelen Rückkopplung mit dem Mikro-Streifenleitungsfilter 3 ist die Source-Elektrode des Feldeffekttransistors 1 direkt mit Masse verbunden. Die Streifenleitungen 4, 5 und 6 stellen die notwendigen Verbindungen zwischen den einzelnen Elementen der Schaltungsanordnung dar. Dabei weist die Streifenleitung 5, die zwischen einem auf Masse legbaren 50-Ohm-Ausgang A und der Drain-Elektrode D des FET's 1 sowie der zum Streifenleitungsfilter 3 führenden Streifenleitung 4 verläuft, eine Stichleitung auf. Auch die Streifenleitung 6 zwischen der Gate-Elektrode G des FET's 1 und dem Streifenleitungsfilter 3 ist für Abstimmungs- bzw. Anpassungszwecke mit einer Stichleitung, einem sogenannten Stub versehen. Mit Ug ist die Gate-Vorspannung des Feldeffekttransistors 1 bezeichnet. Die Betriebsspannung Ub beträgt beispielsweise + 3,5V und der Betriebsstrom 18mA. Bei einer Betriebsfrequenz f von beispielsweise 11,5GHz liegt der Abstimmbereich des Oszillators bei ± 400MHz und die Ausgangsleistung beträgt 13dBm. Die Streifenleitungen des Filters 3 und der zu verbindenden Elemente bestehen beispielsweise aus Kupfer und sind zweckmäßig auf einem aus Kunststoff bestehenden Dielektrikum mit einer Dielektrizitätskonstante εᵣ von z.B. 2,45 aufgebracht. Die Spulensymbole charakterisieren Leitungsinduktivitäten.

In FIG 2 ist eine Ausführungsform des verwendeten Mikro-Streifenleitungsfilters 3 der FIG 1 dargestellt. Das Filter ist aus drei Streifenleitungen zusammengesetzt. Der mittlere Streifen stellt die Verbindung zur auf Masse liegenden Varaktordiode 2 her. Die beiden anderen Streifen stellen den Filtereingang E bzw. den Filterausgang (Out) O dar.

## Patentansprüche

1. Spannungsgesteuerter Mikrowellen-Oszillator mit einem Feldeffekttransistor (1) als Verstärker und einer Varaktor-Diode (2) als frequenzbestimmendes Element, wobei zum Bilden einer parallelen Rückkopplung mit einem abstimmbaren Mikro-Streifenleitungsfilter (3) die Source-Elektrode des Feldeffekttransistors (1) direkt mit Masse verbunden ist, wobei der Varaktor-Diode (2) das abstimmbare Mikro-Streifenleitungsfilter (3) vorgeschaltet ist, das aus drei getrennten Streifenleitungen zusammengesetzt ist, wobei ein mittlerer Streifen zwischen den beiden anderen Streifen angeordnet ist, der mittlere Streifen eine Verbindung zu der auf Masse liegenden Varaktor-Diode (2) herstellt und die beiden anderen Streifen einen Filtereingang (E) bzw. einen Filterausgang (O) darstellen.

2. Mikrowellen-Oszillator nach Anspruch 1, **dadurch gekennzeichnet,** daß der Feldeffekttransistor (1) ein GaAs-Feldeffekttransistor ist.

3. Mikrowellen-Oszillator nach Anspruch 1 oder 2, **dadurch gekennzeichnet,** daß die Varaktordiode (2) eine GaAs-Varaktordiode ist.

4. Mikrowellen-Oszillator nach einem der Ansprüche 1 bis 3, **dadurch gekennzeichnet,** daß das Mikro-Streifenleitungsfilter (3) ein Drei-Streifen-Filter ist.

## Claims

1. Voltage-controlled microwave oscillator having a field-effect transistor (1) as amplifier and a varactor diode (2) as frequency-determining element, the source electrode of the field-effect transistor (1) being connected directly to earth in order to form parallel feedback with a tunable microstrip line filter (3), the tunable microstrip line filter (3) being connected upstream of the varactor diode (2) and being composed of three separate strip lines, a middle strip being arranged between the other two strips, the middle strip establishing a connection to the varactor diode (2), which is connected to earth, and the other two strips constituting a filter input (E) and a filter output (O).

2. Microwave oscillator according to Claim 1, characterized in that the field-effect transistor (1) is a GaAs field-effect transistor.

3. Microwave oscillator according to Claim 1 or 2, characterized in that the varactor diode (2) is a GaAs varactor diode.

4. Microwave oscillator according to one of Claims 1 to 3, characterized in that the microstrip line filter (3) is a three-strip filter.

## Revendications

1. Oscillateur à micro-ondes commandé en tension, comportant un transistor à effet de champ (1) comme amplificateur et une diode varactor (2) comme composant déterminant la fréquence; l'électrode de source du transistor à effet de champ (1) étant, pour former une rétroaction parallèle avec un microfiltre à guide à ruban (3) pouvant être accordé. reliée directement à la masse, et il est monté en série avec la diode varactor (2) le filtre à guide à ruban (3), qui est constitué de trois rubans, l'un des rubans étant disposé entre les deux autres, et établissant la liaison avec la diode varactor (2) reliée à la masse, tandis que les deux autres rubans représentent l'entrée (E) du filtre et la sortie (O) du filtre.

2. Oscillateur à micro-ondes suivant la revendication 1, caractérisé en ce que le transistor à effet de champ (1) ) est un transistor à effet de champ à l'arséniure de gallium.

3. Oscillateur à micro-ondes suivant la revendication 1 ou 2, caractérisé en ce que la diode varactor (2) est une diode varactor à l'arséniure de gallium.

4. Oscillateur à micro-ondes suivant l'une des revendications 1 à 3, caractérisé en ce que le microfiltre à guide à ruban (3) est un filtre à trois rubans.
